# EUROPÄISCHE PATENTSCHRIFT

(11) **EP 2 997 703 B1**
(45) Veröffentlichungstag und Bekanntmachung des Hinweises auf die Patenterteilung: **21.12.2016**
(21) Anmeldenummer: 14727740.4
(22) Anmeldetag: 14.05.2014
(51) Int. Cl.: H04L 25/02, H03F 3/45

(54) **VORRICHTUNG MIT EINER DIFFERENZVERSTÄRKERSCHALTUNG UND EINER EXTRAKTIONSSCHALTUNG**
DEVICE WITH A DIFFERENTIAL AMPLIFIER CIRCUIT AND AN EXTRACTION CIRCUIT
DISPOSITIF COMPRENANT UN CIRCUIT AMPLIFICATEUR DIFFÉRENTIEL ET UN CIRCUIT EXTRACTEUR

(30) Priorität: 17.05.2013 DE 102013209224
(43) Veröffentlichungstag der Anmeldung: 23.03.2016
(73) Patentinhaber: Fraunhofer-Gesellschaft zur Förderung der angewandten Forschung e.V., 80686 München (DE)
(72) Erfinder: SUNDERMEYER, Jan, 90425 Nürnberg (DE); WEBER, Norbert, 91367 Weißenohe (DE)
(74) Vertreter: Stöckeler, Ferdinand
(86) Internationale Anmeldenummer: PCT/EP2014/059883
(87) Internationale Veröffentlichungsnummer: WO 2014/184262

(56) Entgegenhaltungen:
- EP-A1- 2 429 114
- US-A1- 2004 239 374
- GABARA T: "Phantom mode signaling in VLSI systems", ADVANCED RESEARCH IN VLSI, 2001. ARVLSI 2001. PROCEEDINGS. 2001 CONFER ENCE ON 14-16 MARCH 2001, PISCATAWAY, NJ, USA,IEEE, 14. März 2001 (2001-03-14), Seiten 88-100, XP010538448, ISBN: 978-0-7695-1038-5

## Beschreibung

Die vorliegende Erfindung bezieht sich auf eine Vorrichtung mit einem ersten und einem zweiten Leitungspaar zur Übertragung von drei Signalen.

Eine bidirektionale Datenübertragung wird bei kabelgebundenen Datenübertragungssystemen entweder erreicht, indem einem Hin- und einem Rückkanal je ein gesondertes Kabelpaar als Übertragungsmedium zugeordnet wird oder indem ein Senden und Empfangen auf einem Kabelpaar gleichzeitig in einem Vollduplexbetrieb bzw. zeitlich wechselnd in einem Halbduplexbetrieb erfolgt. Pro Kabelpaar wird bei allen Lösungen maximal in jede Richtung ein Datenstrom übertragen, wobei dies im Vollduplexbetrieb gleichzeitig und im Halbduplexbetrieb zeitlich wechselnd erfolgt. Wird ein gesondertes Kabelpaar verwendet, um einen zusätzlichen physikalischen Kanal zu realisieren, kann für die Datenübertragung in jede Richtung ein separates Kabelpaar ununterbrochen genutzt werden.

Bei den bekannten Realisierungen wird die Kapazität des Kabelsystems nicht vollständig ausgenutzt. Um Systeme zu realisieren, die einen Rückkanal benötigen, besteht die Wahl zwischen einer reduzierten Systemkapazität in einem Halbduplexbetrieb, einem eigenständigen Kabelpaar oder der Realisierung einer Vollduplex-Übertragung, die mit großem technischen Aufwand verbunden ist. Die Implementierung eines eigenständigen Kabelpaares zur Schaffung eines weiteren Datenkanals ist hingegen mit, mitunter enormem, finanziellem Aufwand und/oder Materialeinsatz verbunden. Bisherige Lösungen sind zudem in der Bandbreite begrenzt, da die Kabel stark verlustbehaftet sind und eventuell in einer Frequenzcharakteristik lokale Dämpfungsmaxima aufweisen.

Zur Erweiterung der Übertragungsraten mehrerer nebeneinander liegender differentieller Kanäle können Phantomkanäle implementiert werden, indem Gleichtaktsignalanteile partiell getrennt mittels Übertragern über die nebeneinanderliegenden differentiellen Signalstrecken übertragen werden.

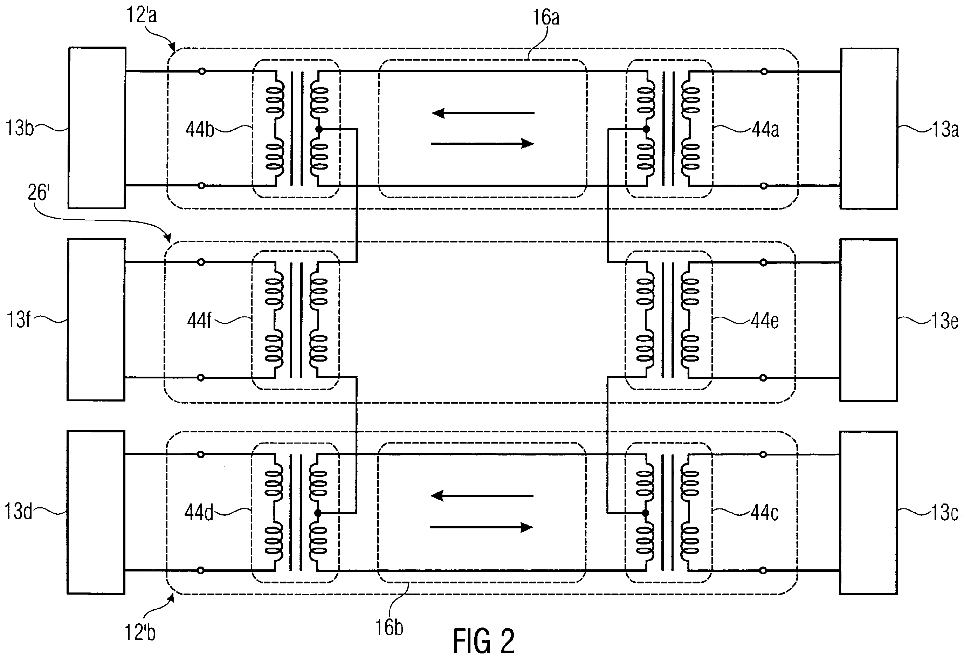

Fig. 2 zeigt eine Vorrichtung 20 gemäß dem Stand der Technik mit zwei bidirektionalen differentiellen Kanälen 12'a und 12'b. Jeder Kanal 12'a und 12'b umfasst je ein Leitungspaar 16a bzw. 16b, wobei an zwei Enden des Leitungspaares 16a je ein Übertrager 44a bzw. 44b und an zwei Enden des Leitungspaares 16b je ein Übertrager 44c und 44d angeordnet ist.

Ein Übertrager 44a-d ist ausgebildet, um ein an einer Primärseite des Übertragers 44a-d von einem benachbart zur Primärseite angeordneten Kommunikationspunkt 13a-d empfangenes Signal zu transformieren und an das an einer Sekundärseite angeordnete Leitungspaar 16a bzw. 16b anzulegen, so dass das angelegte Signal differenziell über die Leitungen des Leitungspaares 16a bzw. 16b an der Sekundärseite eines weiteren Übertragers 44a-d anliegt. Die Übertrager 44a-d sind ferner ausgebildet, um ein an der Sekundärseite anliegendes differenzielles Signal zu transformieren und an der Primärseite für den benachbart zum Übertrager 44a-d angeordneten Kommunikationspunkt 13a-d bereitzustellen, so dass der Kommunikationspunkt 13a-d das bereitgestellte Signal empfängt, wobei die Kommunikationspunkte 13a-e sind ausgebildet, Signale zu senden oder zu empfangen.

Die Übertrager 44a-d ermöglichen eine bidirektionale Übertragung von Signalen über die Kanäle 12'a und 12'b, wie es durch die Pfeile zwischen den Leitungen der Leitungspaare 16a und 16b angedeutet ist. Eine Signalübertragung erfolgt differenziell, so dass mittels der Übertrager 44a-d über die Leitungspaare 16a und 16b übertragene Signale gleichtaktfrei sind.

Ein Phantomkanal 26' umfasst zwei Übertrager 44e und 44f, die an Wicklungsenden der Sekundärseite des jeweiligen Übertragers 44e bzw. 44f mittig mit Wicklungsmittelpunkten der jeweiligen Sekundärseite der Übertrager 44a-d der Kanäle 12'a und 12'b gekoppelt sind, so dass ein erstes Wicklungsende der Sekundärseite des Übertragers 44e einen Mittenabgriff an einer Wicklung der Sekundärseite des Übertragers 44a und ein zweites Wicklungsende der Sekundärseite des Übertragers 44e einen Mittenabgriff an einer Wicklung der Sekundärseite des Übertragers 44c bildet. Die Kopplung der Übertrager 44b und 44d mit dem Übertrager 44f ist symmetrisch zur Kopplung der Übertrager 44a und 44c mit dem Übertrager 44e.

Die Übertrager 44e bzw. 44f sind ausgebildet, um ein an der jeweiligen Primärseite von einem Kommunikationspunkt 13e bzw. 13f empfangenes Signal zu transformieren, wobei die Kopplung der jeweiligen Sekundärseite der Übertrager 44e und 44f mit den Übertragern der Kanäle 12'a und 12'b bewirkt, dass ein Signal vom Kommunikationspunkt 13e bzw. 13f als Gleichtaktsignal an die Leitungen des Leitungspaares 16a bzw. 16b angelegt ist, wobei ein erster Gleichtaktsignalpegel an das Leitungspaar 16a angelegt ist und ein zweiter, zum ersten Gleichtaktsignalpegel invertierter, Gleichtaktsignalpegel an das Leitungspaar 16b angelegt ist.

Durch die Kopplung der Übertrager 44e und 44f an die differentiellen Kanäle 12'a und 12'b wird ein differentielles Signal in zwei zueinander invertierte Gleichtaktsignalpegel umgeformt und diese zu den Pegeln der differentiellen Signale, welche an den Kanälen 12'a und 12'b angelegt sind, addieret. Durch die Invertierung der Gleittaktsignalpegel zueinander findet bezüglich der Summe aller Kanäle wieder eine differentielle Datenübertragung statt. Über die Summe aller Leitungen betrachtet ist das Signal ebenfalls gleichtaktfrei.

Die Mittenabgriffe bewirken eine Trennung der Anteile der differentiellen Signale von den Gleichtaktsignalpegeln, sodass in den Kommunikationspunkten 13e und f durch eine Zusammenführung der Gleichtaktsignalpegel an den Sekundärseiten der Übertrager 44e und 44f eine Rekonstruktion des über den Phantomkanal übertragenen differentiellen Signals erfolgt. Die Übertrager 44a-d filtern die Gleichtaktsignalpegel aufgrund ihrer Verschaltung heraus, sodass ein über den Kanal 12'a bzw. 12'b übertragenes differentielles Signal an der Primärseite des jeweiligen Übertragers 44a-d unbeeinflusst von dem über den Phantomkanal 26' übertragenen Signal bereitgestellt ist.

Nachteilig an dieser Implementierung gemäß dem Stand der Technik ist, dass die Umsetzung bzw. Verstärkung von Signalen durch Übertrager und mithin Transformatoren stattfindet, welche in Bauraum, Stückkosten, Energieeffizienz und EMV-Verhalten nachteilig sind.

In US 2004/0239374 A1 ist eine Vorrichtung beschrieben, bei der ein Zwischenknoten eines ersten Abschlusswiderstandes zwischen einem Paar von Signalleitungen verbunden ist, die ein erstes Differenzsignal mit einer Seite des dritten Differenzsignals als eine gemeinsame Spannung übertragen. Ein Zwischenknoten eines zweiten Abschlusswiderstands ist zwischen einem Paar von Signalleitungen verbunden, die ein zweites Differenzsignal mit der anderen Seite des dritten Differenzsignals übertragen.

Die Aufgabe der Erfindung besteht darin, verlustarme Vorrichtungen und Verfahren zu schaffen, die mit einem einfachen Aufbau eine Übertragung von drei Signalen erlauben.

Diese Aufgabe wird durch eine Vorrichtung gemäß Anspruch 1 und ein Verfahren gemäß Anspruch 8 gelöst.

Ausführungsbeispiele schaffen eine Vorrichtung mit folgenden Merkmalen: einem ersten Leitungspaar, das ausgelegt ist, um ein erstes differentielles Signal zu übertragen;
einem zweiten Leitungspaar, das ausgelegt ist, um ein zweites differentielle Signal zu übertragen;
eine Differenzverstärkerschaltung, die zwei parallel geschaltete Differenzverstärker aufweist und die ausgelegt ist, um basierend auf einem an den Eingängen der parallel geschalteten Differenzverstärker anliegenden dritten differentiellen Signal an einem ersten Ausgang einen ersten Gleichtaktsignalpegel und an einem zweiten Ausgang einen zweiten Gleichtaktsignalpegel zu erzeugen und den ersten Gleichtaktsignalpegel an die Leitungen des ersten Leitungspaares anzulegen und den zweiten Gleichtaktsignalpegel an die Leitungen des zweiten Leitungspaares anzulegen, wobei der erste Gleichtaktsignalpegel und der zweite Gleichtaktsignalpegel zueinander invertiert sind; und
einer Extraktionsschaltung zum Extrahieren von Gleichtaktanteilen auf den Leitungen des ersten Leitungspaares und den Leitungen des zweiten Leitungspaares, die keine Übertrager aufweist.

Bei Ausführungsbeispielen der Erfindung besteht eine Erkenntnis darin, erkannt zu haben, dass durch Anlegen von Gleichtaktsignalpegeln an die Leitungen verschiedener Leitungspaare mit einer Differenzverstärkerschaltung und der Extraktion der Gleichtaktanteile ein zusätzlicher Kanal verlustarm und ohne die bei Übertragern auftretenden Nachteile geschaffen werden kann.

Vorteilhaft an dieser Erfindung ist, dass ein zusätzlich erzeugter Kanal als Rückkanal verwendet werden kann, so dass einem ursprünglich unidirektionalen Kommunikationssystem ein Rückkanal ohne Kapazitätsverlust der ursprünglichen Kanäle zur Verfügung steht und der Rückkanal zum einen gute Eigenschaften bezüglich EMV (elektromagnetische Verträglichkeit) aufweist und zum anderen eine einfache technische Realisierung der Kanaltrennung zwischen Hin- und Rückkanal zulässt.

Gemäß einem Ausführungsbeispiel wird ein Phantomkanal geschaffen, indem zwei Kanäle, welche jeweils ein differentielles Signal übertragen, dadurch erweitert werden, dass ein drittes differentielles Signal an die Eingänge zweier parallel geschalteter Differenzverstärker angelegt wird und die Ausgänge der Differenzverstärker derart mit den Leitungen der ursprünglichen Kanäle gekoppelt werden, dass das dritte Signal in Form eines Gleichtaktsignals zusätzlich zu den ersten beiden differentiellen Signalen an den Leitungen der ursprünglichen Kanäle anliegt. Eine Extraktionsschaltung filtert mithilfe von Spannungsteilern die Gleichtaktsignalanteile aus den beiden differentiellen Kanälen heraus und legt herausgefilterte Gleichtaktsignalpegel an den Eingang eines Differenzverstärkers an, dessen Ausgänge das dritte differentielle Signal für einen Abgriff bereitstellen.

Vorteilhaft an Ausführungsbeispielen ist, dass unter Verwendung von Leitungspaaren, die ausgelegt sind, um Daten in eine Richtung zu übermitteln, ein Rückkanal geschaffen werden kann, so dass eine bidirektionale Kommunikation aufgebaut werden kann, ohne dass neue physikalische Leitungen installiert werden müssen. Zur Realisierung des Rückkanals werden Differenzverstärker verwendet, was bezüglich EMV, Bauraum und Kosteneffizienz Vorteile bringt.

Weitere Vorteile der vorgestellten Ausführungsform bestehen darin, dass eine Trennung zwischen Hin- und Rückkanal technisch einfach realisierbar ist, dass eine Verwendung eines Rückkanals nicht die Datenkapazität des Hinkanals reduziert, bzw. dass in Kombination mit einer Vollduplex-Datenübertragung die Gesamtkapazität eines Datenübertragungssystems steigerbar ist und dass bei verdrillten Kabelsystemen, beispielsweise einer Stern-4-Verkabelung oder einer verdrillten Zweidrahtleitung mit zwei, vier oder acht Paaren, gute EMV-Eigenschaften erzielbar sind.

Weitere vorteilhafte Ausführungsformen sind Gegenstand der abhängigen Patentansprüche.

Bevorzugte Ausführungsbeispiele der vorliegenden Erfindung werden nachfolgend Bezug nehmend auf die beiliegenden Zeichnungen erläutert. Es zeigen:
- Fig. 1: eine schematische Ansicht einer Vorrichtung mit zwei Kanälen und einem Phantomkanal, bei der der Phantomkanal Differenzverstärker umfasst;
- Fig. 2: eine schematische Ansicht einer Vorrichtung gemäß dem Stand der Technik, welche Übertrager umfasst;
- Fig. 3: eine schematische Ansicht eines verdrillten Kabelpaares.

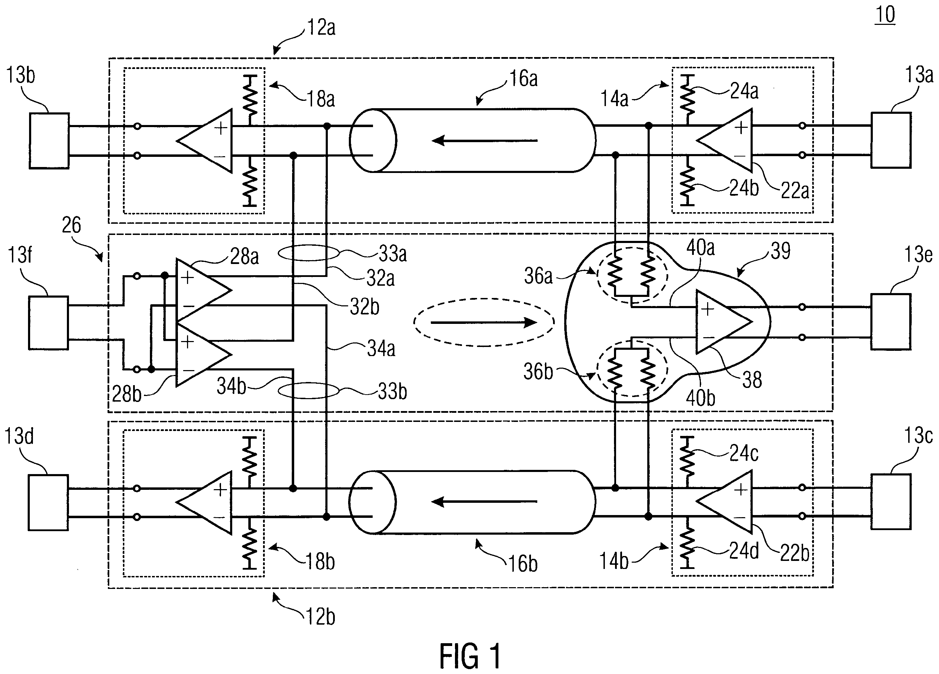

Fig. 1 zeigt eine Vorrichtung 10 mit zwei Kanälen 12a und 12b, die jeweils einen Ausgangstreiber 14a bzw. 14b, ein differentielles Leitungspaar 16a bzw. 16b sowie einen Eingangstreiber 18a bzw. 18b umfassen, wobei das erste differentielle Leitungspaar 16a ausgelegt ist, um ein erstes Signal von einem Kommunikationspunkt 13a zu einem Kommunikationspunkt 13b zu übertragen und das zweite differentielle Leitungspaar ausgelegt ist, um ein zweites differentielles Signal von einem Kommunikationspunkt 13c zu einem Kommunikationspunkt 13d zu übertragen.

Die Ausgangstreiber 14a bzw. 14b umfassen jeweils einen differentiellen Stromtreiber 22a bzw. 22b in Form eines Operationsverstärkers, die Terminierungswiderstände 24a und 24b bzw. 24c und 24d treiben. Die Ausgangstreiber 14a und 14b sind ausgebildet, um einen Ausgang des Kommunikationspunktes 13a bzw. 13c zu treiben und ein vom Kommunikationspunkt 13a bzw. 13c empfangenes Signal umzuformen, bspw. zu verstärken oder zu glätten, und an das jeweilige Leitungspaar 16a bzw. 16b anzulegen.

Die differentiellen Eingangstreiber 18a bzw. 18b sind ausgebildet, um das Signal von dem jeweiligen differentiellen Leitungspaar 16a bzw. 16b zu empfangen und zu verarbeiten. Im Ausführungsbeispiel der Fig. 1 erfolgt die Signalübertragung von einem Ausgangstreiber 14a bzw. 14b hin zu einem Eingangstreiber 18a bzw. 18b, wie durch die Pfeile angedeutet.

Ein Phantomkanal 26 umfasst zwei Ausgangstreiber 28a und 28b, die ausgebildet sind, um eingangsseitig ein drittes Signal von einem Kommunikationspunkt 13f zu empfangen und ausgangsseitig zu verstärken. Die Ausgänge der Ausgangstreiber 28a und 28b des Phantomkanals 26 sind ausgebildet, um je ein Signal einer ersten Polarität 32a bzw. 32b und einer zweiten Polarität 34a bzw. 34b auszugeben und sind je zu einem Ausgangspaar gleicher Polarität kombiniert. Die erste Polarität 32a bzw. 32b der Ausgänge der Ausgangstreiber 28a bzw. 28b bildet einen ersten Gleichtaktsignalpegel 33a, wohingegen die zweite Polarität 34a bzw. 34b der Ausgänge der Ausgangstreiber 28a bzw. 28b einen zweiten Gleichtaktsignalpegel 33b bildet. Der erste Gleichtaktsignalpegel 33a ist an das differentielle Leitungspaar 16a des Kanals 12a angelegt, indem die erste Polarität 32a mit einer ersten Leitung und die erste Polarität 32b mit einer zweiten Leitung des differentiellen Leitungspaares 16a verbunden ist. Der zweite Gleichtaktsignalpegel ist an das differentielle Leitungspaar 16b des Kanals 12b angelegt, indem die zweite Polarität 34a mit einer ersten Leitung und die zweite Polarität 34b mit einer zweiten Leitung des differentiellen Leitungspaares 16b verbunden ist. Durch einen symmetrischen Aufbau der Schaltung des Ausgangstreibers 28a und 28b des Phantomkanals 26 ist die Vorrichtung ausgebildet, um bei einem Anlegen eines Signals an die Eingänge der Ausgangstreiber 28a und28b jeweils identische Signale 32a und 32b bzw. 34a und 34b bereitzustellen.

Ein Anlegen der ersten Polarität 32a und 32b an die Leitungen des differentiellen Leitungspaares 16a führt im Betrieb dazu, dass ein differentielles Signal, welches an den Leitungen des differentiellen Leitungspaares 16a anliegt mit einem Offset in Form des ersten Gleichtaktsignalpegels 33a beaufschlagt wird. Analog wird das an dem differentiellen Leitungspaar 16b anliegende zweite differentielle Signal mit einem Offset in Form des zweiten Gleichtaktsignalpegels 33b beaufschlagt.

Eine Kanalqualität der differentiellen Kanäle 12a bzw. 12b bleibt dadurch unbeeinträchtigt, da die Eingangstreiber 18a und 18b in Form von Differenzverstärkern eine Trennung zwischen dem differentiellen Signal, welches von dem Ausgangstreiber 14a bzw. 14b an die Leitungen des Leitungspaares 16a bzw. 16b angelegt ist und den Gleichtaktsignalpegeln des Phantomkanals durch eine Common-Mode-Unterdrückung bewirkt, indem lediglich die Differenzen zwischen den beiden Leitungen eines Leitungspaares 16a bzw. 16b verstärkt werden. Der Offset durch den ersten bzw. zweiten Gleichtaktsignalpegel 33a bzw. 33b beeinträchtigt die Differenz des Signalpegels des jeweiligen differentiellen Signals nicht und wird an den Eingangstreibern 18a und 18b herausgefiltert. Dies unterdrückt in den differentiellen Kanälen 12a und 12b den Phantomkanal 26, wodurch eine zusätzliche Echounterdrückung unnötig wird.

An einer Empfängerseite des Phantomkanals 26 ist eine Extraktionsschaltung 39 angeordnet, die zwei Widerstandsteiler 36a und 36b sowie einen Differenzverstärker 38 und zwei Leitungen 40a und 40b, welche die Ausgänge der Widerstandsteiler 36a und 36b mit Eingängen des Differenzverstärkers 38 verbinden, umfasst. Die Extraktionsschaltung 39 ist ausgebildet, um das über den Phantomkanal übertragene Signal zu extrahieren und die differentiellen Signale der Kanäle 12a und 12b zu unterdrücken. Der Differenzverstärker 38 ist ausgebildet, um die Differenz der an den Ausgängen der Widerstandsteiler 36a und 36b bereitgestellten Potenziale zu verstärken, wobei der Widerstandsteiler 36a zwischen den Leitungen des differentiellen Leitungspaares 16a und der Widerstandsteiler 36b zwischen den Leitungen des differentiellen Leitungspaares 16b angeordnet ist. Ein Ausgangssignal des Widerstandsteilers 36a und ein Ausgangssignal des Widerstandsteilers 36b sind an einen ersten und einen zweiten Eingang eines Differenzverstärkers 38 des Phantomkanals 26 angelegt.

Der jeweilige Ausgang der Widerstandsteiler 36a und 36b stellt je einen Mittelwert der an den differentiellen Leitungspaaren 16a und 16b angelegten Signale bereit, so dass die differentiellen Signalanteile aufgrund ihrer Invertierung zueinander unterdrückt werden und der halbe Betrag des durch die Gleichtaktsignalpegel 33a oder 33b gebildeten Offsets an dem jeweiligen Ausgang des Widerstandsteilers 36a bzw. 36b bereitgestellt und so ein Common-Mode-Signal in Form des Gleitaktsignals herausgefiltert ist. Ein Potenzial des Signals an einer Leitung 40a zwischen dem Widerstandsteiler 36a und dem Differenzverstärker 38 entspricht der Hälfte des Potenzials des Gleichtaktsignalpegels 33a, wobei ein Potenzial des Signals an der Leitung 40b zwischen dem Widerstandsteiler 36b und dem Differenzverstärker 38 der Hälfte des Potenzials des Gleichtaktsignalpegels 33b entspricht. Die in einer Differenz zwischen dem ersten und zweiten Gleichtaktsignalpegel 33a und 33b liegende Information des dritten Signals bleibt bei einer Halbierung beider Potenziale erhalten.

Der Eingangstreibers 38 ist an Ausgängen mit den Eingängen des Kommunikationspunktes 13e gekoppelt, so dass der Kommunikationspunkt 13e das über den Phantomkanal 26 übertragene Signal empfängt und ausgebildet, den Eingang des Kommunikationspunktes 13e zu treiben. Eine Richtung der Informationsübertragung des Phantomkanals 26 ist dabei der Richtung der Informationsübertragung der differentiellen Kanäle 12a und 12b entgegengerichtet, sodass der Phantomkanal 26 gegenüber den Kanälen 12a und 12b einen Rückkanal bildet.

Der Phantomkanal 26 überträgt seine Daten über Gleichtaktsignalpegel 33a und 33b auf den Leitungen der differentiellen Leitungspaare 16a und 16b, wobei beide Gleichtaktsignalpegel 33a und 33b zueinander invertiert sind, also wieder eine differentielle Datenübertragung zwischen den beiden Leitungspaaren 16a und 16b stattfindet. Über alle Leitungen betrachtet ist das Signal immer noch gleichtaktfrei.

Die Übertragungsrichtung der Kanäle 12a und 12b sowie des Phantomkanals 26 ist abhängig von der Verschaltung der Ausgangs- und Eingangstreiber 14a, 14b, 18a, 18b, 28a und 28b sowie der Extraktionsschaltung 39 beliebig realisierbar, so dass sowohl eine Signalübertragung der Kanäle 12a und 12b in entgegengesetzte Richtungen ermöglicht ist und der Phantomkanal 26 eine Steigerung der Übertragungskapazitäten in eine der beiden Richtungen bereitstellt, als eine Signalübertragung des Phantomkanals in eine gleiche Richtung wie die Kanäle 12a und 12b umsetzbar ist und der Phantomkanal 26 die Kapazität eines unidirektionalen Übertragungssystems bewirkt.

Wird alternativ zu obiger Beschreibung eine Übertragung im Vollduplex- oder Halbduplexbetrieb genutzt, so können Signale auch bidirektional über die Kanäle 12a und 12b übertragen werden. In diesem Fall erhöht ein ebenfalls bidirektionaler Phantomkanal 26 die Gesamtkapazität des Systems. Im Falle eines Vollduplexbetriebs liegt eine Kapazitätssteigerung bei 50 %

Im Unterschied zum Stand der Technik werden keine Übertrager verwendet, um Phantomkanal 26 und differentiellen Kanal 12a bzw. 12b zu trennen. Des Weiteren ergeben sich schaltungstechnische Vorteile, indem speziell der Rückkanal eines Kommunikationssystems als Phantomkanal 26 realisiert wird, da dies den Hauptkanälen 12a und 12b die maximale Datenrate über alle Adernpaare hinweg weiter verfügbar macht.

Speziell bei der Verwendung eines Stern-4-Kabels, aber auch bei verdrillten Kabelpaaren mit mehr als einem Kabelpaar, erlaubt der Phantomkanal eine Datenübertragung, die von außen betrachtet differentiell erfolgt und durch das Verdrillen eine reduzierte Abstrahlung bzw. Empfindlichkeit gegenüber Störstrahlung besitzt.

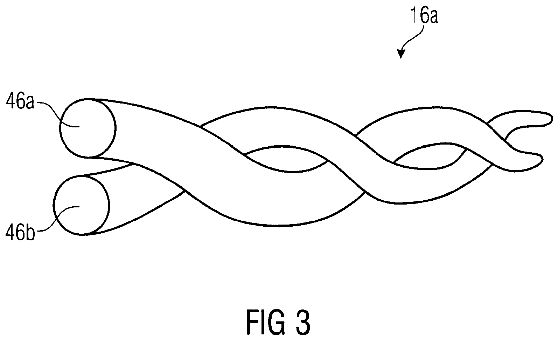

Fig. 3 zeigt das differentielles Leitungspaar 16a, das zwei Leitungen 46a und 46b umfasst. Verdrillte Leitungen bieten insbesondere bei differentiellen Signalen Vorteile bezüglich der Signaldämpfung, da die von einer Hinleitung generierten elektrischen oder magnetischen Felder von einer mit der Hinleitung verdrillten Rückleitung durch deren elektrische oder magnetische Felder kompensiert werden.

Alternative Ausführungsbeispiele umfassen Kanäle, die mehrere verdrillte Adernpaare umfassen oder bei denen mehrere Adern gemeinsam verdrillt sind.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Vorrichtung mit folgenden Merkmalen:
einem ersten Leitungspaares (16a), das ausgelegt ist, um ein erstes differentielles Signal zu übertragen;
einem zweiten Leitungspaar (16b), das ausgelegt ist, um ein zweites differentielles Signal zu übertragen; **dadurch gekennzeichnet, dass** die Vorrichtung folgendes aufweist:
eine Differenzverstärkerschaltung, die zwei parallel geschaltete Differenzverstärker (28a, 28b) aufweist, und die ausgelegt ist, um basierend auf einem an den Eingängen der parallel geschalteten Differenzverstärker (28a, 28b) anliegenden dritten differentiellen Signal an einem ersten Ausgang einen ersten Gleichtaktsignalpegel (33a) und an einem zweiten Ausgang einen zweiten Gleichtaktsignalpegel (33b) zu erzeugen und den ersten Gleichtaktsignalpegel (33a) an die Leitungen (46a; 46b) des ersten Leitungspaares (16a) anzulegen und den zweiten Gleichtaktsignalpegel (33b) an die Leitungen des zweiten Leitungspaares (16b) anzulegen, wobei der erste Gleichtaktsignalpegel (33a) und der zweite Gleichtaktsignalpegel (33b) zueinander invertiert sind; und
eine Extraktionsschaltung (39) zum Extrahieren von Gleichtaktanteilen auf den Leitungen (46a; 46b) des ersten Leitungspaares (16a) und den Leitungen des zweiten Leitungspaares (16b), die keine Übertrager aufweist.

2. Vorrichtung gemäß Anspruch 1, mit Ausgangstreibern (14a; 14b; 28a; 28b) und Eingangstreibern (16a; 16b), die ausgebildet sind, um das erste Signal und das zweite Signal in eine Richtung zu übertragen und das dritte Signal in eine entgegengesetzte Richtung zu übertragen.

3. Vorrichtung nach Anspruch 1 oder 2, bei der die Extraktionsschaltung (39) einen Differenzverstärker (38) umfasst.

4. Vorrichtung nach Anspruch 3. bei der der Differenzverstärker (38) der Extraktionsschaltung (39) ausgebildet ist, um die Differenz eines Anteils des ersten Gleichtaktanteils (33a) und des zweiten Gleichtaktanteils (33b) zu verstärken.

5. Vorrichtung nach einem der Ansprüche 1 bis 4 bei der
die Leitungen (46a; 46b) des ersten Leitungspaares (16a) paarweise verdrillt sind und die die Leitungen des zweiten Leitungspaares (16b) paarweise verdrillt sind.

6. Vorrichtung nach einem der Ansprüche 1 bis 4 bei der
die Leitungen (46a; 46b) des ersten Leitungspaares (16a) und des zweiten Leitungspaares (16a) eine gemeinsame Verdrillung umfassen.

7. Verfahren zum Übertragen eines Signals mit folgenden Schritten:
Übertragen eines ersten differentiellen Signals über ein erstes Leitungspaar (16a);
Übertragen eines zweiten differentiellen Signals über ein zweites Leitungspaar (16b); **gekennzeichnet durch** folgende Schritte:
Erzeugen eines ersten Gleichtaktsignalpegels (33a) an einem ersten Ausgang und eines zweiten Gleichtaktsignalpegels (33b) an einem zweiten Ausgang mit einer Differenzverstärkerschaltung, die zwei parallel geschaltete Differenzverstärker (28a, 28b) aufweist, basierend auf einem dritten differentiellen Signal, das an den Eingängen der parallel geschalteten Differenzverstärker (28a, 28b) angelegt wird, so dass der erste Gleichtaktsignalpegel (33a) und der zweite Gleichtaktsignalpegel (33b) zueinander invertiert sind und Anlegen des ersten Gleichtaktsignalpegels (33a) an die Leitungen (46a; 46b) des ersten Leitungspaares (16a) und Anlegen des zweiten Gleichtaktsignalpegels (33b) an die Leitungen des zweiten Leitungspaares (16b);
Extrahieren von Gleichtaktanteilen auf den Leitungen (46a; 46b) des ersten Leitungspaares (16a) und den Leitungen des zweiten Leitungspaares (16b) mittels einer Extraktionsschaltung (39), die keine Übertrager aufweist.

## Claims

1. Apparatus, comprising:
a first pair of lines (16a) that is implemented to transmit a first differential signal;
a second pair of lines (16b) that is implemented to transmit a second differential signal; **characterized in that** the apparatus comprises:
a differential amplifier circuit comprising two differential amplifiers connected in parallel (28a, 28b) and that is implemented to generate, based on a third differential signal applied to the inputs of the differential amplifiers connected in parallel (28a, 28b), a first common-mode signal level (33a) at a first output and a second common-mode signal level (33b) at a second output and to apply the first common-mode signal level (33a) to the lines (46a; 46b) of the first pair of lines (16a) and to apply the second common-mode signal level (33b) to the lines of the second pair of lines (16b), wherein the first common-mode signal level (33a) and the second common-mode signal level (33b) are inverted to one another; and
an extraction circuit (39) for extracting common-mode portions on the lines (46a; 46b) of the first pair of lines (16a) and the lines of the second pair of lines (16b) comprising no transducers.

2. Apparatus according to claim 1, comprising output drivers (14a; 14b; 28a; 28b) and input drivers (16a; 16b) that are implemented to transmit the first signal and the second signal in one direction and to transmit the third signal in an opposite direction.

3. Apparatus according to claim 1 or 2, wherein the extraction circuit (39) comprises a differential amplifier (38).

4. Apparatus according to claim 3, wherein the differential amplifier (38) of the extraction circuit (39) is implemented to amplify the difference of a portion of the first common-mode portion (33a) and the second common-mode portion (33b).

5. Apparatus according to any one of claims 1 to 4, wherein
the lines (46a; 46b) of the first pair of lines (16a) are twisted in pairs and the lines of the second pair of lines (16b) are twisted in pairs.

6. Apparatus according to any one of claims 1 to 4, wherein
the lines (46a; 46b) of the first pair of lines (16a) and the second pair of lines (16b) comprise a common twisting.

7. Method for transmitting a signal, comprising:
transmitting a first differential signal via a first pair of lines (16a);
transmitting a second differential signal via a second pair of lines (16b); **characterized by**:
generating a first common-mode signal level (33a) at a first output and a second common-mode signal level (33b) at a second output with a differential amplifier circuit comprising two differential amplifiers connected in parallel (28a, 28b) based on a third differential signal applied to the inputs of the differential amplifiers connected in parallel (28a, 28b), such that the first common-mode signal level (33a) and the second common-mode signal level (33b) are inverted to one another and applying the first common-mode signal level (33a) to the lines (46a; 46b) of the first pair of lines (16a) and applying the second common-mode signal level (33b) to the lines of the second pair of lines (16b);
extracting common-mode portions on the lines (46a; 46b) of the first pair of lines (16a) and the lines of the second pair of lines (16b) by means of an extraction circuit (39) comprising no transducers.

## Revendications

1. Dispositif aux caractéristiques suivantes:
une première paire de lignes (16a) qui est conçue pour transmettre un premier signal différentiel;
une deuxième paire de lignes (16b) qui est conçue pour transmettre un deuxième signal différentiel; **caractérisé par le fait que** le dispositif présente ce qui suit:
un circuit amplificateur différentiel qui présente deux amplificateurs différentiels connectés en parallèle (28a, 28b) et qui est conçu pour générer, sur base d'un troisième signal différentiel présent aux entrées des amplificateurs différentiels connectés en parallèle (28a, 28b), à une première sortie un premier niveau de signal de mode commun (33a) et à une deuxième sortie un deuxième niveau de signal de mode commun (33b) et pour appliquer le premier niveau de signal de mode commun (33a) aux lignes (46a; 46b) de la première paire de lignes (16a) et pour appliquer le deuxième niveau de signal de mode commun (33b) aux lignes de la deuxième paire de lignes (16b), le premier niveau de signal de mode commun (33a) et le deuxième niveau de signal de mode commun (33b) étant inversés l'un par rapport à l'autre; et
un circuit extracteur (39) destiné à extraire des parts de mode commun sur les lignes (46a; 46b) de la première paire de lignes (16a) et les lignes de la deuxième paire de lignes (16b) qui ne présente pas de transmetteurs.

2. Dispositif selon la revendication 1, avec des pilotes de sortie (14a; 14b; 28a; 28b) et des pilotes d'entrée (16a; 16b) qui sont conçus pour transmettre le premier signal et le deuxième signal dans une direction et le troisième signal dans une direction opposée.

3. Dispositif selon la revendication 1 ou 2, dans lequel ledit circuit extracteur (39) présente un amplificateur différentiel (38).

4. Dispositif selon la revendication 3, dans lequel l'amplificateur différentiel (38) du circuit extracteur (39) est conçu pour amplifier la différence d'une part de la première part de mode commun (33a) et de la deuxième part de mode commun (33b).

5. Dispositif selon l'une des revendications 1 à 4, dans lequel
les lignes (46a; 46b) de la première paire de lignes (16a) sont torsadées par paire et les lignes de la deuxième paire de lignes (16b) sont torsadées par paire.

6. Dispositif selon l'une des revendications 1 à 4, dans lequel
les lignes (46a; 46b) de la première paire de lignes (16a) et de la deuxième paire de lignes (16a) comportent une torsion commune.

7. Procédé pour transmettre un signal aux étapes suivantes consistant à:
transmettre un premier signal différentiel par l'intermédiaire d'une première paire de lignes (16a);
transmettre un deuxième signal différentiel par l'intermédiaire d'une deuxième paire de lignes (16b); **caractérisé par** les étapes suivantes consistant à:
générer un premier niveau de signal de mode commun (33a) à une première sortie et un deuxième niveau de signal de mode commun (33b) à une deuxième sortie par un circuit amplificateur différentiel qui présente deux amplificateurs différentiels connectés en parallèle (28a, 28b) sur base d'un troisième signal différentiel qui est appliqué aux entrées des amplificateurs différentiels connectés en parallèle (28a, 28b), de sorte que le premier niveau de signal de mode commun (33a) et le deuxième niveau de signal de mode commun (33b) soient inversés l'un par rapport à l'autre et appliquer le premier niveau de signal de mode commun (33a) aux lignes (46a; 46b) de la première paire de lignes (16a) et appliquer le deuxième niveau de signal de mode commun (33b) aux lignes de la deuxième paire de lignes (16b);
extraire des parts de mode commun sur les lignes (46a; 46b) de la première paire de lignes (16a) et les lignes de la deuxième paire de lignes (16b) au moyen d'un circuit extracteur (39) qui ne présente pas de transmetteurs.
